# NEUE EUROPÄISCHE PATENTSCHRIFT

(11) **EP 1 921 746 B2**
(45) Veröffentlichungstag und Bekanntmachung des Hinweises auf die Entscheidung über den Einspruch: **12.06.2013**
(45) Hinweis auf die Patenterteilung: 02.09.2009
(21) Anmeldenummer: 06023272.5
(22) Anmeldetag: 08.11.2006
(51) Int. Cl.: H03F 3/21, H03F 3/60, H04R 1/22, H04R 25/00

(54) **Schaltungsanordnung zur Einstellung der Ausgangsleistung und/oder des Frequenzganges eines Endverstärkers für ein Hörhilfegerät**
Electronic circuit for the adjustment of the output power and / or frequency characteristic of the power amplifier for a hearing aid
Circuit électronique pour l'ajustage de la puissance de sortie et / ou de la réponse en fréquence d'un amplificateur pour une prothèse auditive

(43) Veröffentlichungstag der Anmeldung: 14.05.2008
(73) Patentinhaber: Siemens Audiologische Technik GmbH, 91058 Erlangen (DE)
(72) Erfinder: Alexander, Christian, 91052 Erlangen (DE); Dickel, Thomas, 96155 Buttenheim (DE); Sauer, Gunter, 91052 Erlangen (DE); Weidner, Tom, 91056 Erlangen (DE)
(74) Vertreter: Maier, Daniel Oliver

(56) Entgegenhaltungen:
- EP-A2- 0 098 421
- EP-B1- 0 098 421
- WO-A-01/39546
- WO-A1-90/09760
- WO-A2-98/47314
- GB- - 1 506 295
- GB-A- 2 091 065
- US-A- 4 548 082
- US-A1- 2002 153 947
- US-B1- 6 590 448
- US-B1- 6 934 400
- LEVITT H: "ISSUES IN THE DEVELOPMENT OF DIGITAL HEARING AIDS" SPEECH TECHNOLOGY, MAN-MACHINE VOICE COMMUNICATIONS, MEDIA DIMENSIONS INC. NEW YORK, US, Bd. 4, Nr. 3, 1. September 1988 (1988-09-01), Seiten 62-65, XP000111145 ISSN: 0744-1355

## Beschreibung

Die Erfindung betrifft ein Hörhilfegerät mit einer Schaltungsanordnung zur Einstellung der Ausgangsleistung und/oder des Frequenzganges eines Endverstärkers des Hörhilfegerätes nach der Gattung des Anspruchs 1. Hörhilfegeräte zur Kompensierung einer Schwerhörigkeit eines Menschen sind bereits bekannt. Bei einem bekannten Hörhilfegerät wird das Umgebungsgeräusch von einem Mikrofon aufgenommen, mit einem Vorverstärker verstärkt, mit einer Signalverarbeitungseinheit gefiltert, angepasst und die Lautstärke geregelt. Über einen Endverstärker wird dann das Nutzsignal auf einem angeschlossenen Hörer direkt in das Ohr des Patienten übertragen. Das gesamte Hörhilfegerät ist sehr kompakt aufgebaut und befindet sich am oder im Ohr des Patienten.

Da der Grad der Schwerhörigkeit bei den einzelnen Patienten sehr unterschiedlich sein kann, muss für jeden einzelnen Fall das Hörhilfegerät so programmiert werden, dass der Patient insbesondere auch sehr leise Tonsignale oder Geräusche hören und verstehen kann. Sehr laute Tonsignale werden dagegen weniger stark verstärkt, da sie vom Patienten besser wahrgenommen werden können. Des weiteren besteht das Problem, dass der Rauschabstand ausreichend hoch ist, damit ein verstärktes Tonsignal mit möglichst niedrigem Rauschpegel abgegeben werden kann, um dadurch eine möglichst gute Verständigung zu erzielen. Um diese Probleme zu lösen, wird bei bekannten Hörhilfegeräten der vom Lautsprecher abgegebene Schalldruckpegel in Abhängigkeit von dem am Mikrofon aufgenommenen Schaltdruckpegel gesteuert. Der übertragene Frequenzbereich wird dabei in zwei oder mehrere Verstärkungskanäle aufgeteilt und dabei von entsprechenden Regelkreisen getrennt gesteuert. Die Aufteilung in Teilbereiche erfolgt durch einsangsseitige Filter, die mit einem eigenen Dynamibregler verbunden sind.

Aus der DE 2641675 A1 ist ein Hörhilfegerät mit einem Tonfrequenzverstärker bekannt, der die von einem Mikrofon aufgenommenen Tonsignale verstärkt und an einen Hörer weiterleitet. Der Tonfrequenzverstärker hat wenigstens zwei parallel geschaltete Übertragungskanäle. Jeder Übertragungskanal enthält eingangsseitig jeweils einen Filter mit einem nachgeschalteten Regelverstärker. Dabei sind die Filter derart ausgelegt, dass jedes Filter einen anderen Teilbereich des Tonfrequenzbereiches durchlässt. Des weiteren ist in jedem Übertragungskanal hinter dem Regelverstärker ein einstellbares frequenzabhängiges Netzwerk ausgebildet. Die einzelnen Übertragungskanäle werden ausgangsseitig zusammengeführt und auf einen Endverstärker geführt, der schließlich den Hörer ansteuert.

Aus der WO 01/39546 A1 ist ferner ein Hörhilfegerät bekannt, bei dem die Sprachverständlichkeit durch gezieltes Unterdrücken von Stör- und Nebengeräuschen verbessert wird. Hierbei wird das eingehende Audiosignal in zwei verschiedenen zueinander komplementären Signalverarbeitungspfaden verarbeitet, um bestimmte durch das Resonanzverhalten der verwendeten Ausgangswandler bei der Wiedergabe von Audiosignalen auftretende Störungen zu kompensieren.

Aus der US6590448 ist ein Endverstärker mit verbessertem Signal/Rausch Verhältnis bekannt, bei dem die Ausgänge mehrerer Endstufen, mit im Wesentlichen gleichen Eigenschaften, über steuerbare Schalteinrichtungen elektrisch mit einem Ausgang verbindbar sind.

Aus der US6934400 ist ein Hörhilfegerät bekannt, bei dem der Dynamikumfang durch schaltbare Impedanzen an den Grad der Schwerhörigkeit anpassbar ist.

Der Erfindung liegt die Aufgabe zugrunde, ein Hörhilfegerät bereitzustellen, das mit sehr einfachen Mitteln für unterschiedliche Leistungsklassen adaptierbar ist. Diese Aufgabe wird mit den Merkmalen des Anspruchs 1 gelöst.

Bei dem erfindungsgemäßen Hörgerät mit der Schaltungsanordnung zur Einstellung der Ausgangsleistung ergibt sich der Vorteil, dass für alle Leistungsklassen bzw. für alle Schwerhörigkeitsgrade nur eine einzige Fertigungsplattform benötigt wird. Dadurch kann das Hörhilfegerät wesentlich kostengünstiger hergestellt werden. Ein weiterer Vorteil ist, dass im Vergleich zum bekannten Stand der Technik die Einstellung der Ausgangsleistung bzw. des Frequenzganges auf sehr einfache Weise erreicht werden kann, da der Endverstärker wenigstens zwei Endstufen aufweist, die mit einem separaten Ausgang ausgebildet sind. Jede Endstufe ist mit einer vorgegebenen festen Ausgangsleistung beziehungsweise mit einem vorgegebenen Frequenzgang ausgebildet. Mit Hilfe einer sehr einfachen, steuerbaren Schalteinrichtung können die Ausgänge von wenigstens zwei Endstufen je nach Bedarf parallel geschaltet werden und treiben dann gemeinsam den Hörer. Durch diese additive Verknüpfung der Endstufen kann zum Beispiel durch einen Akustik-Fachmann praktisch jede beliebige Ausgangsleistung beziehungsweise Frequenzgang eingestellt oder programmiert werden. Dadurch kann das Hörhilfegerät individuell und mit sehr einfachen Mitteln an den Schwerhörigkeitsgrad des Patienten individuell angepasst werden.

Erfindungsgemäß sind die einzelnen Endstufen mit einer individuellen, unterschiedlichen Ausgangsleistung und/oder Frequenzgang ausgebildet. Bei mehreren Endstufen, die mit einer entsprechend abgestuften Ausgangsleistung hergestellt sind, können somit durch einfaches Parallelschalten alle gewünschten Ausgangsleistungen erzeugt werden.

Durch die Ausbildung der einzelnen Endstufen mit einer individuellen, unterschiedlichen Ausgangsleistung und/oder unterschiedlichem Frequenzgang wird insbesondere auch das unvermeidbare Rauschen (weißes Rausches) reduziert, da das Rauschsignal mit zunehmender Ausgangsleistung ansteigt. Beispielsweise kann bei einem geringeren Schwerhörigkeitsgrad durch Reduzierung der Anzahl der aktiven Endstufen das übertragene Nutzsignal bei minimalem Rauschen optimal angepasst werden.

Die Parallelschaltung der Ausgänge der einzelnen Endstufen erfolgt mit einer Schalteinrichtung. Die Schalteinrichtung ist als elektronischer Schalter ausgebildet. Der Status wird in einem nicht flüchtigen Speicher, beispielsweise einem EEPROM oder einem Flash-Speicher abgelegt. In weiterer Ausgestaltung der Erfindung ist vorgesehen, dass zwischen der Schalteinrichtung und dem Hörer eine externe Beschaltung angeordnet wird. Mit dieser externen Beschaltung kann ebenfalls die Ausgangsleistung der betroffenen Endstufe begrenzt werden. Es ist vorgesehen, dass die externe Beschaltung passive Bauelemente, vorzugsweise einen Widerstand, ein R/C-Filter, einen Koppelkondensator oder dergleichen aufweist. Dadurch kann auch der Frequenzgang in einer gewünschten Weise beeinflusst werden. Beispielsweise können mit einem Koppelkondensator die hohen Frequenzen stärker hervorgehoben werden.

Ein weiterer Aspekt der Erfindung besteht darin, dass jede Endstufe mit einem separaten Hörer verbunden werden kann. Dabei können die einzelnen Hörer für verschiedene Frequenzbereiche, beispielsweise als Hochtöner, Mitteltöner oder Tieftöner ausgebildet sein.

Es ist vorgesehen, dass die Schaltungsanordnung als integrierte Schaltung ausgebildet ist und vorzugsweise auf einem Hörgeräte-Chip integriert ist.

Ein Ausführungsbeispiel der Erfindung ist in der Zeichnung dargestellt und wird in der nachfolgenden Beschreibung näher erläutert.
Figur 1 zeigt in schematischer Darstellung ein Blockschaltbild eines bekannten Hörhilfegerätes,
Figur 2 zeigt ein erstes Ausführungsbeispiel der Erfindung mit einem Endverstärker, der mit drei Endstufen ausgebildet ist,
Figur 3 zeigt ein Blockschaltbild eines zweiten Ausführungsbeispiels der Erfindung und
Figur 4 zeigt ein Blockschaltbild eines dritten Ausführungsbeispiels der Erfindung.

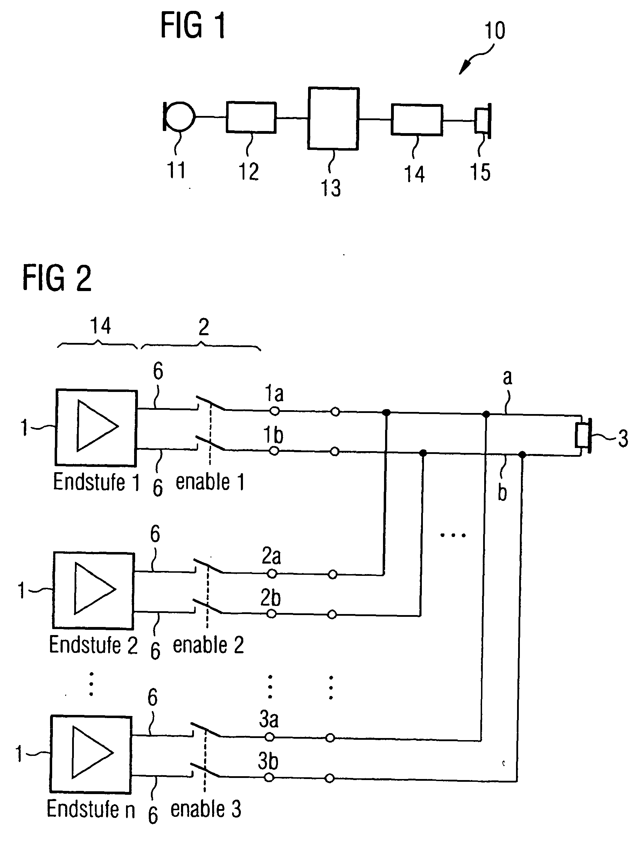

Zum besseren Verständnis der Erfindung wird zunächst anhand eines vereinfachten Blockschaltbildes entsprechend der Figur 1 der Aufbau eines bekannten Hörhilfegerätes näher erläutert. Ein Hörhilfegerät 10 weist im Wesentlichen ein Mikrofon 11 auf, das die akustischen Tonsignale, beispielsweise Sprachsignale oder Umgebungsgeräusche aufnimmt und in elektrische Signale umwandelt. Da die aufgenommenen akustischen Tonsignale sowohl Nutzfrequenzen wie auch Störfrequenzen enthalten, werden diese in entsprechende elektrische Signale umgesetzt und in einem nachgeschalteten Vorverstärker 12 verstärkt. An den Vorverstärker 12 ist eine Signalverarbeitungseinheit 13 angeschlossen, mit der die elektrischen Signale gefiltert und soweit verarbeitet werden, dass ein möglichst störungsfreies Nutzsignal entsteht. Dazu werden in der Regel mehrere Übertragungskanäle verwendet, die mit entsprechenden Filtern und Reglern ausgebildet sind.

Der Ausgang der Signalverarbeitungseinheit 13 ist mit einem Eingang eines Endverstärkers 14 verbunden, der das gefilterte Nutzsignal verstärkt und damit einen nachgeschalteten Hörer 15 ansteuert.

Des weiteren enthält die Signalverarbeitungseinheit 13 einen Lautstärkeregler, mit dem eine gewünschte akustische Lautstärke am Hörer 15 einstellbar ist. Dieser schematisch dargestellte Aufbau eines Hörhilfegerätes ist per se bekannt.

Bisher wurde beispielsweise ein Endverstärker mit einer festen Ausgangsleistung verwendet. Das bedeutet, dass bei einem geringen Schwerhörigkeitsgrad die Ausgangsleistung zwar verringert werden kann, das Rauschsignal der Endstufe bleibt jedoch unverändert hoch. Eine gezielte Anpassung an die Schwerhörigkeit ist mit dem bekannten Gerät daher nur bedingt möglich.

Figur 2 zeigt in schematischer Darstellung ein Blockschaltbild für ein erstes Ausführungsbeispiel der Erfindung. Der Figur 2 ist ein Endverstärker 14 entnehmbar, der beispielhaft mit drei unabhängigen Endstufen 1 ausgebildet ist. Die Anzahl der Endstufen 1 ist nicht erfindungswesentlich. Es ist vorgesehen, dass wenigstens zwei unabhängige Endstufen 1 ausgebildet sind. Jede Endstufe 1 weist einen zweipoligen Ausgang 6 auf, der mit einer steuerbaren Schalteinrichtung 2 verbunden ist. Die steuerbare Schalteineinrichtung 2 ist vorzugsweise als Halbleiterschalter ausgebildet und wird von einer in Figur 2 nicht dargestellten Steuereinrichtung betätigt beziehungsweise so programmiert, dass die Schalterstellung entweder dauerhaft geschlossen (enable 1, enable 2, enable 3) oder dauerhaft geöffnet ist. Dargestellt ist jeweils eine geöffnete Schalterstellung. Die Steuereinrichtung weist im Wesentlichen einen nicht flüchtigen Speicher auf, der beispielsweise als EEPROM oder als Flash-Speicher ausgebildet sein kann. In dem nicht flüchtigen Speicher wird für jede Endstufe eine Statusinformation für die Schaltstellung der Schaltkontakte gespeichert.

Jede der drei in Figur 2 dargestellten Schalteinrichtungen 2 ist ausgangsseitig miteinander parallel geschaltet, d.h. dass die Anschlüsse 1a,2a und 3a sowie die Anschlüsse 1b,2b und 3b miteinander verbunden sind. An diese Parallelschaltung ist ein Hörer 3 an den Leitungen a und b angeschlossen. Durch Schließen der Schaltkontakte, die bei der Ausführung als integrierte Schaltung in Form entsprechender Schalttransistoren ausgebildet ist, ist somit jede Endstufe 1 individuell mit dem Hörer 3 verbindbar. Werden beispielsweise alle 3 zweipoligen Schalter der Schalteinrichtung 2 geschlossen, dann sind automatisch alle drei Endstufen 1 parallel zum Hörer 3 geschaltet. Bei zwei geschlossenen Schaltkontakten der Schalteinrichtung 2 sind dagegen nur die entsprechenden beiden Endstufen 1 mit dem Hörer 3 verbunden, die dritte Endstufe ist in diesem Fall unwirksam.

In alternativer Ausgestaltung der Erfindung ist vorgesehen, dass die einzelnen Endstufen 1 mit einer abgestuften Ausgangsleistung oder Verstärkung bzw. für unterschiedliche Frequenzbänder ausgebildet sind.

Die einzelnen Endstufen 1 werden zusammen mit der Schalteinrichtung 2 vorzugsweise als integrierte Schaltung ausgeführt und auf einem Chip des Hörhilfegerätes 10 integriert. Beispielsweise können zwei, fünf, zehn oder noch mehr Endstufen auf der integrierten Schaltung angeordnet werden. Die einzelnen Endstufen 1 werden dabei von dem gleichen Eingangssignal angesteuert. Die Endstufen können nach bekannten Schaltungsarten, beispielsweise als Emitterfolger, als Darlington-Verstärker, als komplementäre Endstufe, in digitalisierter Form als Class D Endstufe mit H-Brücke oder dergleichen ausgeführt sein.

Wenn beispielsweise jede Endstufe mit einer Ausgangsleistung von 1 ausgebildet ist, dann ergibt sich bei der Parallelschaltung der drei Endstufen 1 eine gesamte Ausgangsleistung von 3, mit der der Hörer 3 angesteuert werden kann. Haben dagegen die einzelnen Endstufen 1 eine unterschiedliche Ausgangsleistung, beispielsweise abgestuft in 1, 3, 5, 10 - Schritten, dann kann durch eine entsprechende Aktivierung der Schalteinrichtung 2 die gesamte Ausgangsleistung je nach Stellung der Schaltkontakte entsprechend gesteuert werden. Die Schritte 1,3,5,10 sind entsprechende Leistungseinheiten.

Es ist des weiteren vorgesehen, dass die Endstufen 1 mit unterschiedlichem Frequenzgang ausgebildet sind. Dadurch kann das Eingangssignal mehr oder weniger stark angehoben bzw. gedämpft werden, so dass durch die Änderung des Frequenzganges ein besseres Hörergebnis und eine bessere Dynamik erzielbar ist. Durch Verwendung der zuvor beschriebenen Mehrkanalendstufe wird in vorteilhafter Weise eine einfache Klassifizierung der Leistung des Hörhilfegerätes 10 erreicht. Die gewünschte Ausgangsleistung ist durch Anwahl der unterschiedlichen Endstufen 1 bzw. paralleles Betreiben mehrerer Endstufen einfach programmierbar.

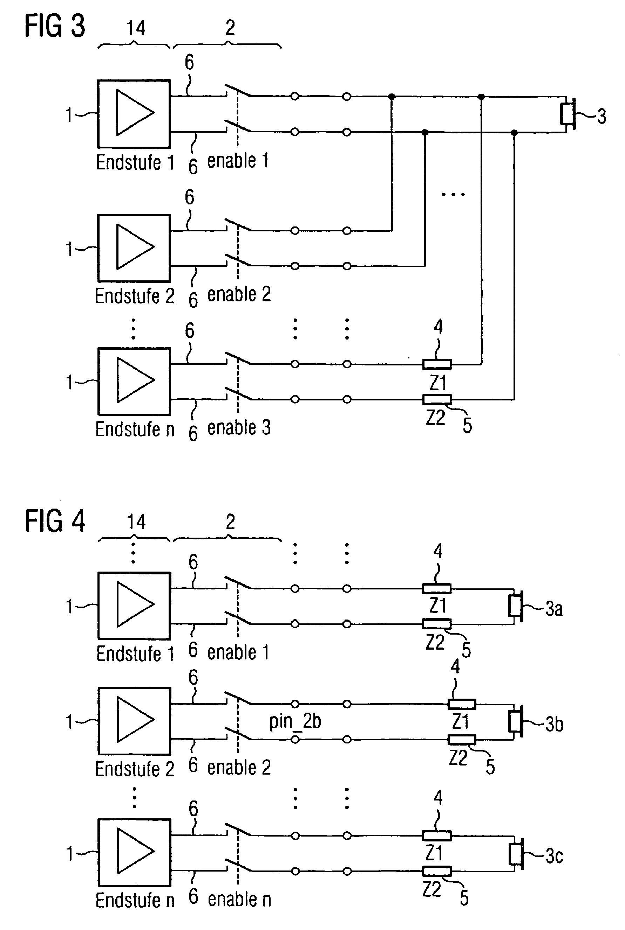

Figur 3 zeigt ein zweites Ausführungsbeispiel der Erfindung. Die Schaltungsanordnung ist die gleiche, wie sie zuvor zu Figur 2 näher erläutert wurde. Allerdings wurde in diesem Fall bei der dritten Endstufe 1 zwischen dem Ausgang der Schalteinrichtung 2 und den Eingangsklemmen des Hörers 3 eine externe Beschaltung mit passiven Bauelementen 4, 5 angeordnet. Die passiven Elemente sind beispielsweise als Widerständen, R/C-Filter oder als Koppelkondensator ausgeführt. Durch die externe Beschaltung kann somit eine individuelle Endstufe 1 mit einer bestimmten Ausgangsleistung und/oder einem vorgegebenen Frequenzgang modifiziert werden. Durch Parallelschalten der einzelnen Endstufen 1 kann somit der Frequenzgang für das zu übertragende Signal vorgegeben werden.

Figur 4 zeigt ein drittes Ausführungsbeispiel der Erfindung. Bei diesem Ausführungsbeispiel sind wiederum die drei Endstufen 1 mit der Schalteinrichtung 2 verbunden. Allerdings werden in diesem Fall die einzelnen Endstufen nicht parallel geschaltet. Vielmehr ist jede Endstufe 1 über die Schalteinrichtung 2 mit jeweils einem separaten Hörer 3a, 3b, 3c elektrisch verbunden. Des weiteren ist vor jedem Hörer 3a, 3b, 3c eine externe Beschaltung mit passiven Bauelementen 4, 5 vorgeschaltet. Die Wirkungsweise dieser Anordnung ist die gleiche, wie sie bereits zu den Ausführungsbeispielen 1 und 2 erläutert wurde, beispielsweise können mit einem Koppelkondensator die hohen Frequenzen stärker hervorgehoben werden.

Des weiteren ist vorgesehen, dass die einzelnen Hörer 3a, 3b, 3c unterschiedliche Eigenschaften aufweisen. Beispielsweise sind die drei Hörer für den Tieftonbereich, den Hochtonbereich und den Mitteltonbereich ausgebildet. Durch Aufteilung der Tonfrequenzen gelingt es, insbesondere das physikalisch bedingte und unvermeidbare Rauschen stärker zu unterdrücken und damit die Verständlichkeit des Nutzsignals zu verbessern.

Dieses ist insbesondere für einen schwer hörgeschädigten Patienten von besonderer Bedeutung.

Durch die Nutzung des Mehrkanalsystems können somit die unterschiedlichen Frequenzbereiche getrennt angesteuert werden und auf entsprechende Hörer 3a, 3b, 3c ausgegeben werden. Die Hörer 3a, 3b, 3c können dabei in einem Gehäuse angeordnet sein, so dass sich eine besonders kleine Bauform für das Hörhilfegerät ergibt.

## Patentansprüche

1. Hörhilfegerät (10) mit einem Mikrofon (11), einer Signalverarbeitungseinheit (13) und einem Endverstärker (14),
wobei der Endverstärker (14) wenigstens zwei Endstufen (1) umfasst, die jeweils mit einem separaten Ausgang (6) ausgebildet sind,
**dadurch gekennzeichnet,**
**dass** die maximale Ausgangsleistung und/oder der Frequenzgang des Endverstärkers (14) mithilfe steuerbarer Schalteinrichtungen (2) begrenzbar ist,
wobei jeder Ausgang (6) mit einer steuerbaren Schalteinrichtung (2) verbunden ist, mit deren Hilfe die jeweilige Endstufe (1) wahlweise mit einem Hörer (3) elektrisch verbindbar ist, wobei die Schalteinrichtung (2) wenigstens ein elektronisches Schaltelement aufweist, mit dem die Ausgänge (6) von zwei Endstufen (1) parallel schaltbar sind, und
**dass** die einzelnen Endstufen (1) mit einer individuellen, unterschiedlichen Ausgangsleistung und/oder einem individuellen, unterschiedlichen Frequenzgang ausgebildet sind.

2. Hörhilfegerät (10) nach Anspruch 1,
**dadurch gekennzeichnet,**
**dass** jeder Ausgang (6) der Endstufen (1) zweipolig schaltbar ausgebildet ist.

3. Hörhilfegerät (10) nach einem der vorhergehenden Ansprüche,
**dadurch gekennzeichnet,**
**dass** mit Hilfe der Schalteinrichtung (2) wenigstens zwei Endstufen (1) mit einem gemeinsamen Hörer (3) elektrisch verbindbar sind.

4. Hörhilfegerät (10) nach einem der vorhergehenden Ansprüche,
**dadurch gekennzeichnet,**
**dass** wenigstens zwei Endstufen (1) mit jeweils einem separaten Hörer (3a,3b,3c) elektrisch verbindbar sind.

5. Hörhilfegerät (10) nach Anspruch 4,
**dadurch gekennzeichnet,**
**dass** die einzelnen Hörer (3a,3b,3c) mit einem unterschiedlichen Frequenzgang ausgebildet sind.

6. Hörhilfegerät (10) nach einem der vorhergehenden Ansprüche,
**dadurch gekennzeichnet,**
**dass** zwischen einer Schalteinrichtung (2) und dem ihr zugeordneten Hörer (3) eine externe Beschaltung (4,5) angeordnet ist.

7. Hörhilfegerät (10) nach Anspruch 6,
**dadurch gekennzeichnet,**
**dass** die externe Beschaltung (4,5) mit einem passiven Bauteil ausgebildet ist.

8. Hörhilfegerät (10) nach Anspruch 7,
**dadurch gekennzeichnet,**
**dass** die externe Beschaltung (4,5) mit einem Widerstand, mit einem Kondensator und/oder mit einer Induktivität ausgebildet ist.

9. Hörhilfegerät (10) nach einem der vorhergehenden Ansprüche,
**dadurch gekennzeichnet,**
**dass** eine die Endstufen (1) und die zugehörigen Schalteinrichtungen (2) umfassende Schaltungsanordnung als integrierte Schaltung ausgebildet ist.

10. Hörhilfegerät nach einem der vorhergehenden Ansprüche,
**dadurch gekennzeichnet,**
**dass** die Ausgangsleistungen der einzelnen Endstufen (1) zueinander abgestuft ausgebildet sind.

11. Hörhilfegerät nach einem der vorhergehenden Ansprüche,
**dadurch gekennzeichnet,**
**dass** für jede Endstufe (1) ein elektronischer Schalter vorgesehen ist, der mithilfe einer Steuereinrichtung gesteuert wird.

12. Hörhilfegerät nach Anspruch 11,
**dadurch gekennzeichnet,**
**dass** der Status des elektronischen Schalters für jede Endstufe (1) in einem nicht-flüchtigen Speicher gespeichert wird.

13. Hörhilfegerät nach einem der vorhergehenden Ansprüche,
**dadurch gekennzeichnet,**
**dass** die Endstufen (1) als Emitterfolger, als Darlington-Verstärker, als komplementäre Endstufen oder als Class D Endstufen mit H-Brücke ausgebildet sind.

## Claims

1. Hearing aid device (10) comprising a microphone (11), a signal processing unit (13) and a power amplifier (14), with the power amplifier (14) having at least two end stages (1) which are each embodied with a separate output (6),
**characterised in that**
the maximum output power and/or the frequency response of the power amplifier (14) can be limited with the aid of controllable switching facilities (2),
with each output (6) being connected to a controllable switching facility (2), with the aid of which the respective end stage (1) can optionally be electrically connected to a receiver (3) wherein
the switching facility (2) comprises at least one electronic switching element, with which the outputs (6) of two end stages (1) can be switched in parallel and the individual end stages (1) are embodied with an individual, different output power and/or an individual, different frequency response.

2. Hearing aid device (10) according to claim 1,
**characterised in that**
each output (6) of the end stages (1) is embodied to be switchable in a two-pole fashion.

3. Hearing aid device (10) according to one of the preceding claims,
**characterised in that**
with the aid of the switching facility (2), at least two end stages (1) can be electrically connected to a common receiver (3).

4. Hearing aid device (10) according to one of the preceding claims,
**characterised in that**
at least two end stages (1) can be electrically connected in each instance to a separate receiver (3a, 3b, 3c).

5. Hearing aid device (10) according to claim 4,
**characterised in that**
the individual receivers (3a, 3b, 3c) are embodied with a different frequency response.

6. Hearing aid device (10) according to one of the preceding claims,
**characterised in that**
an external circuit (4, 5) is arranged between a switching facility (2) and the receiver (3) assigned thereto.

7. Hearing aid device (10) according to claim 6,
**characterised in that**
the external circuit (4, 5) is embodied with a passive component.

8. Hearing aid device (10) according to claim 7,
**characterised in that**
the external circuit (4, 5) is embodied with a resistor, a capacitor and/or with an inductor.

9. Hearing aid device (10) according to one of the preceding claims,
**characterised in that**
a circuit arrangement including the end stages (1) and the associated switching facilities (2) is embodied as an integrated circuit.

10. Hearing aid device according to one of the preceding claims,
**characterised in that**
the output powers of the individual end stages (1) are embodied in a graduated fashion.

11. Hearing aid device according to one of the preceding claims,
**characterised in that**
an electronic switch is provided for each end stage (1), said switch being controlled with the aid of a control facility.

12. Hearing aid device according to claim 11,
**characterised in that**
the status of the electronic switch is stored in a nonvolatile memory for each end stage (1).

13. Hearing aid device according to one of the preceding claims,
**characterised in that**
the end stages (1) are embodied as emitter followers, as Darlington amplifiers, as complementary end stages or as Class D end stages with H-bridge circuits.

## Revendications

1. Prothèse ( 10 ) auditive ayant un microphone ( 11 ), une unité ( 13 ) de traitement du signal et un amplificateur d'extrémité,
dans laquelle l'amplificateur ( 14 ) d'extrémité comprend au moins deux étages (1) d'extrémité, qui sont constitués respectivement en ayant une sortie ( 16 ) distincte,
**caractérisée**
**en ce que** la puissance maximum de sortie et/ou la réponse fréquentielle de l'amplificateur ( 14 ) d'extrémité peut être limitée à l'aide de dispositif ( 2 ) de commutation pouvant être commandé,
chaque sortie ( 6 ) étant reliée à un dispositif ( 2 ) de commutation pouvant être commandé, à l'aide duquel l'étage ( 1 ) d'extrémité respectif peut être relié électriquement au choix à un écouteur (3), le dispositif (2) de commutation ayant au moins un élément de commutation électronique, par lequel les sorties ( 6 ) de deux étages ( 1 ) d'extrémité peuvent être montées en parallèle, et
**en ce que** les divers étages (1) d'extrémité sont constitués en ayant une puissance individuelle de sortie différente et/ou une réponse fréquentielle individuelle différente.

2. Prothèse (10) auditive suivant la revendication 1, **caractérisée en ce que** chaque sortie (6) des étages ( 1 ) d'extrémité peut être montée de manière bipolaire.

3. Prothèse ( 10 ) auditive suivant l'une des revendications précédentes, **caractérisée en ce que**, à l'aide du dispositif (2) de commutation, au moins deux étages ( 1 ) d'extrémité peuvent être reliés électriquement à un écouteur ( 3 ) commun.

4. Prothèse ( 10 ) auditive suivant l'une des revendications précédentes, **caractérisée en ce qu'**au moins deux étages ( 1 ) d'extrémité peuvent être reliés électriquement respectivement à un écouteur ( 3a, 3b, 3c ).

5. Prothèse (10) auditive suivant la revendication 4, **caractérisée en ce que** les divers écouteurs ( 3a, 3b, 3c ) sont constitués en ayant une réponse fréquentielle différente.

6. Prothèse ( 10 ) auditive suivant l'une des revendications précédentes, **caractérisée en ce qu'**un circuit ( 4, 5 ) extérieur est disposé entre un dispositif (2) de commutation et l'écouteur ( 3 ) qui lui est associé.

7. Prothèse ( 10 ) auditive suivant la revendication 6, **caractérisée en ce que** le circuit ( 4, 5 ) extérieur est constitué en ayant un composant passif.

8. Prothèse ( 10 ) auditive suivant l'une des revendications précédentes, **caractérisée en ce que** le circuit ( 4, 5 ) extérieur est constitué en ayant une résistance, un condensateur et/ou une inductance.

9. Prothèse ( 10 ) auditive suivant l'une des revendications précédentes, **caractérisée en ce qu'**un montage comprenant les étages ( 1 ) d'extrémité et les dispositifs ( 2 ) de commutation associés est constitué sous la forme d'un circuit intégré.

10. Prothèse ( 10 ) auditive suivant l'une des revendications précédentes, **caractérisée en ce que** les puissances de sortie des divers étages (1) d'extrémité sont étagées les unes par rapport aux autres.

11. Prothèse ( 10 ) auditive suivant l'une des revendications précédentes, **caractérisée en ce qu'**il est prévu, pour chaque étage (1) d'extrémité, un commutateur électronique, qui est commandé à l'aide d'un dispositif de commande.

12. Prothèse (10) auditive suivant la revendication 11, **caractérisée en ce que** le statut de l'interrupteur électronique de chaque étage d'extrémité est mémorisé dans une mémoire non volatile.

13. Prothèse ( 10 ) auditive suivant l'une des revendications précédentes, **caractérisée en ce que** les étages ( 1 ) d'extrémité sont constitués en émetteur suiveur, en amplificateur Darlington, en étage d'extrémité complémentaire ou en étage d'extrémité de classe D à pont H.
